(19) Europäisches Patentamt
European Patent Office
Office européen des brevets

(11) Numéro de publication: **0 252 784 B1**

# (12) FASCICULE DE BREVET EUROPEEN

(45) Date de publication du fascicule du brevet: **12.09.90**

(51) Int. Cl.[5]: **C30B 15/00**, C30B 11/00, C30B 29/22

(21) Numéro de dépôt: **87401288.3**

(22) Date de dépôt: **09.06.87**

## (54) Gallates mixtes de lanthanide-magnésium, laser utilisant des monocristaux de ces gallates.

(30) Priorité: **10.06.86 FR 8608364**

(43) Date de publication de la demande: **13.01.88 Bulletin 88/2**

(45) Mention de la délivrance du brevet: **12.09.90 Bulletin 90/37**

(84) Etats contractants désignés: **DE GB**

(56) Documents cités:
**EP-A- 0 033 990**
**EP-A- 0 043 776**

(73) Titulaire: **CENTRE NATIONAL DE LA RECHERCHE SCIENTIFIQUE (CNRS), 15, Quai Anatole France, F-75007 Paris(FR)**
Titulaire: **COMMISSARIAT A L'ENERGIE ATOMIQUE, 29-31, rue de la Fédération, F-75015 Paris(FR)**

(72) Inventeur: **Ferrand, Bernard, 115, rue Plassarot, F-38340 Voreppe(FR)**
Inventeur: **Grange, Yves, 4, rue Jean Macé, F-38000 Grenoble(FR)**
Inventeur: **Lefebvre, Dominique, 1, rue Jules Guesde, F-94140 Alfortville(FR)**
Inventeur: **Thery, Jeannine, 15, rue Poliveau, F-75005 Paris(FR)**
Inventeur: **Vivien, Daniel, 6 Bis, rue Kraustadt, F-92380 Garches(FR)**

(74) Mandataire: **Mongrédien, André et al, c/o BREVATOME 25, rue de Ponthieu, F-75008 Paris(FR)**

EP 0 252 784 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet des gallates mixtes de lanthanide-magnésium obtenus notamment sous forme de monocristaux et trouvant une application particulière dans le domaine des micro-lasers pour l'optique intégrée, ou les télécommunications par fibres optiques et dans le domaine des lasers de puissance émettant dans l'infrarouge, le visible ou l'ultraviolet permettant notamment d'effectuer des traitements de matériaux (soudure, perçage, marquage, traitement de surface), des réactions photochimiques, la fusion thermo-nucléaire contrôlée, ou la polarisation des atomes d'un gaz tel que l'hélium. Les microlasers peuvent aussi être utilisés dans le domaine médical pour le traitement de la peau ou en microchirurgie.

Comme oxydes mixtes de lanthanide-magnésium, on connaît en particulier des gallates mixtes de lanthane-magnésium du type magnétoplombite préparés, sous forme pulvérulente, pour la première fois par la Société Philips. Ces gallates dopés par le manganèse possèdent des propriétés de luminescence qui ont notamment été décrites dans un article intitulé "Luminescence of $Mn^{2+}$ in $SrGa_{12}O_{19}$, $LaMgGa_{11}O_{19}$, and $BaGa_{12}O_{19}$" paru dans Jal of solid state chemistry 7, 468-473 (1973) de J. Verstegen. Ces gallates obtenus uniquement sous forme de poudre possèdent des propriétés luminescentes importantes permettant de les utiliser dans des dispositifs d'affichage. En revanche, ils ne présentent pas l'effet laser.

On connaît aussi par les documents FR-A-2 205 733 et US-A-4 216 408 des gallates de lanthane-magnésium contenant notamment du strontium, dopés au manganèse, présentant aussi des propriétés luminescentes, mais pas l'effet laser.

Comme autres oxydes mixtes de lanthanide-magnésium, on connait en particulier des aluminates de lanthane-néodyme-magnésium, appelés LNA, de formule : $La_{1-x}Nd_xMgAl_{11}O_{19}$ avec $0 < x \leq 1$. Ces aluminates ont notamment fait l'objet des brevets FR-A-2 448 134 et EP-A-0 043 776.

Ces aluminates obtenus sous forme monocristalline présentent des propriétés lasers comparables à celles que possèdent le grenat d'yttrium et d'aluminium dopé au néodyme, connu sous l'abréviation YAG : Nd, et l'ultraphosphate de néodyme ($NdP_5O_{14}$), émettant dans l'infrarouge.

Le LNA présente deux longueurs d'ondes d'émission laser particulièrement intéressantes à 1,054 et 1,083 micromètres, encadrant celle du YAG à 1,064 micromètres. En outre, il présente un autre domaine de longueurs d'onde d'émission autour de 1,32 micromètres, domaine correspondant à la plus faible atténuation par les fibres optiques en silice permettant ainsi la transmission d'un maximum d'informations avec un minimum de perte.

Toutefois, le rendement de l'émission laser du LNA est faible comme celui du YAG, ce qui ne permet pas actuellement de l'utiliser dans toutes les applications.

L'invention a justement pour objet des gallates mixtes de lanthanide-magnésium pouvant être fabriqués sous forme de monocristaux, présentant une émission laser dont le rendement est supérieur à celui du LNA.

Selon l'invention, ces gallates mixtes se caractérisent en ce qu'ils présentent la formule (I) suivante :

$$\left[La_{1-x}M^1_x\right]_{(1-z/3)k}Mg_{(1-z)k}\left[Ga_{1-v-t}M^2_vCr_t\right]_{(11+z)k}O_{19k} \quad (I)$$

dans laquelle $M^1$ est choisi parmi le néodyme, le praséodyme, le cérium, les couples néodyme-cérium et praséodyme-cérium, ces éléments étant trivalents ; $M^2$ représente au moins un élément trivalent choisi parmi l'aluminium, le scandium et/ou l'indium à condition que le nombre d'atomes totaux de scandium et/ou d'indium par unité formulaire soit inférieur à 0,15(11+z)k ; k représente un nombre allant de 0,94 à 1 ; x représente un nombre allant de 0 à 1 ; t représente un nombre tel que $0 \leq t \leq 0,05$ à condition que t soit 0, lorsque x = 0, et que x soit 0, lorsque t = 0 ; v représente un nombre tel que $0 \leq v+t < 1$ ; z représente un nombre allant de 0 à 0,5. En outre, ces gallates sont monophasés et présentent une structure cristalline du type magnétoplombite, à maille hexagonale.

Les composés selon l'invention peuvent être fabriqués sous forme de monocristaux présentant un rendement laser supérieur à celui du LNA permettant ainsi de concurrencer le YAG et le $NdP_5O_{14}$ pour toutes leurs applications lasers.

En effet, les inventeurs ont trouvé que le rendement insuffisant de l'émission laser du LNA était principalement lié à un champ cristallin trop élevé au site du néodyme dû à une distance trop faible entre les atomes de néodyme et d'oxygène. Les inventeurs ont alors pensé à augmenter les distances néodyme-oxygène en effectuant une substitution totale ou partielle de l'aluminium par du gallium et eventuellement par, du scandium et/ou de l'indium dans le réseau du LNA, le gallium, le scandium et l'indium ayant des rayons ioniques plus élevés que celui de l'aluminium.

De façon avantageuse, $M^2$ représente au moins en partie l'aluminium.

De préférence, $M^1$ représente le néodyme.

Lorsque le gallate de lanthanide-magnésium répond à la formule $La_{1-x}Nd_xMg(Ga_{1-v}Al_v)_{11}O_{19}$, v doit de plus satisfaire à la condition suivante : $v > 0,143(x-0,3)$ pour $0,3 \leq x \leq 1$, alors que pour $0 < x < 0,3$, v peut prendre toutes les valeurs comprises entre 0 et 1, y compris la valeur 0.

Le gallate mixte selon l'invention dans lequel $M^1$ représente le néodyme ou le couple néodyme-cérium peut être réalisé sous forme monocristalline et utilisé comme émetteur laser dans un laser de puissance, dans le domaine de l'infrarouge.

Dans le cas du couple néodyme-cérium, le gallate mixte selon l'invention présente avantageusement la formule suivante :

$La_{1-x}(Nd_{1-p}Ce_p)_xMg(Ga_{1-v}Al_v)_{11}O_{19}$, p étant un nombre tel que $0 \leq p \leq 1$.

En particulier, v vaut 0,5 et x vaut 0,2 ou 0,5.

Par laser de puissance, il faut comprendre un laser émettant dans les 100 W.

Lorsque $M^1$ représente le praséodyme ou le couple praséodyme-cérium, les gallates mixtes correspondants, réalisés sous forme monocristalline, peuvent être utilisés comme émetteurs lasers dans un laser notamment de puissance, émettant dans le visible et en particulier dans le jaune et dans le rouge.

Les gallates selon l'invention dans lequel $M^1$ représente le praséodyme présentent en particulier la formule suivante :

$La_{1-x}Pr_xMg(Ga_{1-v}Al_v)_{11}O_{19}$.

Par exemple v peut prendre les valeurs 0,4 ou 0,7 et x peut prendre toutes les valeurs entre 0 et 1, y compris la valeur 1 et ce quel que soit v.

Lorsque $M^1$ représente le cérium, les gallates mixtes correspondants, réalisés sous forme de monocristaux, peuvent être utilisés comme émetteurs lasers émettant dans l'ultraviolet ou le bleu-violet avec accordabilité.

Ces gallates à base de cérium présentent en particulier la formule suivante :

$La_{1-x}Ce_xMg(Ga_{1-v}Al_v)_{11}O_{19}$ avec $0 < x \leq 1$.

Lorsque dans la formule (I) x = 0 et par conséquent t non nul, les gallates mixtes correspondants, réalisés sous forme de monocristaux peuvent être utilisés comme émetteurs lasers notamment de puissance, émettant dans le rouge et le proche infrarouge avec accordabilité entre 680 et 800 nm, l'émission laser étant due au chrome.

Les gallates au chrome présentent notamment la formule suivante :

$LaMg(Ga_{1-v-t}Al_vCr_t)_{11}O_{19}$, avec $0 \leq v+t < 1$ et t0 et en particulier t est égal à 0,01.

On sait que l'effet laser dépend de certains paramètres et en particulier de la durée de vie de l'état excite $E_1$ des ions à l'origine de l'effet laser (niveau d'énergie supérieur au niveau fondamental). Si la durée de vie de l'état excité $E_1$ est suffisamment importante, l'inversion de population, correspondant à un nombre d'ions dans l'état excité supérieur au nombre d'ions dans l'état fondamental, peut avoir lieu.

Pour le néodyme, l'état excité $E_1$ correspond au niveau d'énergie $^4F_{3/2}$, pour le praséodyme, l'état excité pour une émission visible est le niveau d'énergie $^3P_0$ et pour le cérium l'état excité correspond à la configuration $(5d)^1$. Les transitions possibles entre le niveau excité $E_1$ et le niveau fondamental du néodyme, du praséodyme, du cérium et du chrome sont notamment décrites dans un article de la revue Phys. Status Sol. (a) 87, 11(1985) intitulé "Achievements in the Field of Physics and Spectroscopy of Activated Laser Crystals" de A. Kaminskii.

Des études ont montré que plus le composé mixte contenait du lanthane, plus la durée de vie de l'état excité augmentait. En revanche, l'intensité de la fluorescence augmente avec la concentration en ions luminophores. Toutefois, une trop grande quantité d'ions luminophores favorise des interactions entre ces ions, nuisibles à la fluorescence.

Dans le cas du néodyme, l'utilisation d'un composé satisfaisant à la formule (I) ci-dessus dans lequel x est tel que $0{,}1 \leq x \leq 0{,}5$ semble un très bon compromis en ce qui concerne la quantité d'ions néodyme.

Pour réaliser le peuplement de l'état excité $E_1$, on excite les ions luminescents jusqu'à un niveau d'énergie $E_2$ supérieur à l'état excité $E_1$. Le peuplement de l'état d'énergie supérieur $E_2$ est obtenu par absorption de lumière ou pompage optique. Le niveau d'énergie $E_2$ étant très instable, les ions luminescents (praséodyme, cérium, néodyme, chrome) se désexcitent spontanément jusqu'à l'état d'énergie excité $E_1$.

Etant donné que les pics d'absorption du néodyme sont très étroits, la substitution partielle du gallium par du chrome favorise l'absorption de lumière par le gallate. En effet, le chrome présente dans le visible deux bandes d'absorption beaucoup plus larges que celles du néodyme, une première bande allant environ de 400 à 500 nm et une seconde bande de 600 à 700 nm.

Après avoir été porté à l'état excité par absorption de lumière dans l'une ou l'autre de ces bandes spectrales, le chrome transfère son énergie aux ions néodyme permettant ainsi le peuplement du niveau d'énergie $E_1$. Cette transmission d'énergie est possible étant donné que la différence d'énergie entre l'état fondamental et l'état excité des ions chrome est voisine de la différence d'énergie entre l'état fondamental et l'état super excité $E_2$ des ions néodyme.

Le pompage optique dans les gallates de l'invention peut aussi être assuré en substituant une partie du praséodyme ou du néodyme par du cérium. En effet, le cérium présente des bandes d'absorption aussi larges que celles du chrome, dans le domaine de l'ultraviolet ou du violet-bleu et la différence d'énergie entre l'état fondamental et l'état excité du cérium est voisine de la différence d'énergie entre l'état fondamental et l'état super excité du néodyme ou du praséodyme.

On peut aussi envisager un codopage chrome-cérium dans le cas spécifique du néodyme.

Les bandes d'absorption larges pour le chrome et le cérium sont liées à la nature de leurs transitions électroniques mettant en jeu un ou plusieurs niveaux "d". Le chrome et le cérium sont appelés des sensibilisateurs d'émission laser alors que le néodyme et le praséodyme sont appelés des activateurs d'émission laser. Le sensibilisateur et l'activateur sont choisis en fonction de la longueur d'onde utilisée pour le pompage optique et de la longueur d'onde d'émission souhaitée.

En l'absence de praséodyme et de néodyme, le chrome ou le cérium joue le rôle d'activateur.

Les gallates mixtes selon l'invention sont obtenus en mélangeant intimement dans des proportions stoechiométriques les poudres du commerce de haute pureté des oxydes de lanthane, de magnésium, de gallium, de chrome, de $M^1$ et de $M^2$ puis en portant le mélange obtenu à une température de l'ordre de 1400°C. Après broyage du produit obtenu on obtient une poudre qui peut alors être traitée en vue de réaliser par solidification un monocristal de gallate mixte.

Les poudres de gallate peuvent aussi être obtenues par coprécipitation à l'état amorphe des hydroxydes de lanthane, de $M^1$, de magnésium, de gallium, de $M^2$ et de chrome. Cette coprécipitation est réalisée avec de l'ammoniaque dans une solution aqueuse contenant un mélange des nitrates des différents éléments métalliques du gallate.

Les nitrates de magnésium, d'aluminium et de chrome sont ceux du commerce tandis que les nitrates de gallium, de lanthane, de néodyme, de praséodyme et de cérium sont obtenus respectivement par dissolution du gallium métal, de $La_2O_3$, de $Nd_2O_3$, de $Pr_2O_3$ et de $Ce_2O_3$ dans l'acide nitrique.

Le mélange de nitrates obtenus, non filtré, est tout d'abord traité à 300°C en atmosphère ventilée jusqu'à sa déshydratation et l'élimination complète du nitrate d'ammonium puis est porté à une température de 1300°C. La poudre obtenue, après broyage, peut alors être traitée en vue de réaliser par solidification un monocristal.

Les oxydes pulvérulents des différents éléments utilisés se présentent sous la forme d'une poudre ayant une granulométrie allant de 1 à 10 micromètres et une pureté supérieure à 99,99% afin d'obtenir un rendement aussi élevé que possible pour l'émission laser.

Les monocristaux de gallates peuvent être obtenus par fusion du matériau pulvérulent, obtenu précédemment, en creuset de platine suivi d'un refroidissement lent pour les compositions riches en gallium. Cette méthode peut être utilisée pour obtenir des monocristaux de petite taille de l'ordre de quelques mm utilisables dans les microlasers.

Pour obtenir des monocristaux de plusieurs centimètres, on emploie avantageusement la méthode de croissance par tirage Czochralski utilisant un creuset d'iridium ou d'autre métal (Mo par exemple).

D'autres méthodes d'élaboration de monocristaux à partir de la fusion peuvent être utilisées telles que la méthode de Verneuil, de zone fondue, de Bridgmann, etc.

Les procédés de fabrication décrits ci-dessus ont permis d'obtenir un grand nombre de gallates selon l'invention sous forme de poudre et/ou de monocristaux dont la structure a été identifiée par diffraction de rayons X et dont les paramètres cristallins ont été mesurés.

D'autres caractéristiques et avantages de l'invention ressortiront mieux de la description qui va suivre, donnée à titre purement illustratif et non limitatif, en référence aux figures annexées, dans lesquelles :

- la figure 1 est un diagramme de phases définissant le domaine d'existence des gallates monophasés selon l'invention de formule $La_{1-x}Nd_xMg(Ga_{1-v}Al_v)_{11}O_{19}$ ; l'abscisse donne la concentration en néodyme, c'est-à-dire la valeur de x, et l'ordonnée donne la concentration en aluminium, c'est-à-dire la valeur de v;
- la figure 2 donne les paramètres cristallins a et c, exprimés en nanomètres, en fonction de v pour les gallates selon l'invention de formule $La_{0,9}Nd_{0,1}Mg(Ga_{1-v}Al_v)_{11}O_{19}$ ;
- la figure 3 dónne l'intensité de fluorescence $I_f$, en unités arbitraires, en fonction de la teneur en néodyme/cm$^3$ N pour l'alumino-gallate de formule $La_{1-x}Nd_xMg(Ga_{0,6}Al_{0,4})_{11}O_{19}$ (courbe 7) et pour le LNA (courbe 8) ;
- la figure 4 représente le spectre de fluorescence du néodyme pour un monocristal de formule :

$La_{0,95}Nd_{0,05}Mg(Ga_{0,45}Al_{0,55})_{11}O_{19}$

c'est-à-dire la variation de $J_f$, en unités arbitraires, en fonction de la longueur d'onde lambda exprimée en micromètres ; et

- la figure 5 représente schématiquement un laser pulsé de puissance utilisant un monocristal du gallate selon l'invention.

Sur la figure 1, on a représenté le domaine d'existence des phases des gallates de type magnétoplombite répondant conformément à l'invention à la formule :

$(La_{1-x}Nd_x)Mg(Ga_{1-v}Al_v)_{11}O_{19}$

ce qui correspond dans la formule (I) à t= 0, z = 0 et k = 1. La composition en aluminium est portée en ordonnée, la composition en néodyme en abscisse. Ce diagramme a été tracé expérimentalement.

Pour v = 0, les gallates présentent la formule :

$La_{1-x}Nd_xMgGa_{11}O_{19}$

ce qui correspond à une substitution totale de l'aluminium par du gallium dans le LNA. Les essais de synthèse du composé $NdMgGa_{11}O_{19}$ ont conduit à des mélanges d'oxydes parmi lesquels le grenat $Nd_3Ga_5O_{12}$, le spinelle $MgGa_2O_4$ et la galline $Ga_2O_3\beta$. En revanche, des gallates monophasés de type magnétoplombite ont été obtenus pour 0<x<0,3. Ces composés sont ceux de la droite 1 de la figure 1.

Au-dessus de x=0,3, on observe la présence de grenat $Nd_3Ga_5O_{12}$.

A titre d'exemple de gallates monophasés obtenus sous forme de poudre à 1400°C, pour lesquels v = 0 et 0<x<0,3, on peut citer les composés A, B et C (voir figure 1) répondant respectivement aux formules :

- A : $La_{0,9}Nd_{0,1}MgGa_{11}O_{19}$

- B : $La_{0,8}Nd_{0,2}MgGa_{11}O_{19}$

- C : $La_{0,75}Nd_{0,25}MgGa_{11}O_{19}$.

Pour x = 1, les gallates répondent à la formule :

$NdMg(Ga_{1-v}Al_v)_{11}O_{19}$.

Les inventeurs ont trouvé que la substitution totale du lanthane par le néodyme n'est possible que dans les gallates dans lesquels une partie du gallium est substituée par de l'aluminium. Des gallates monophasés du type magnétoplombite ont été obtenus pour v>0,1.

Comme exemples de composés appartenant à la droite 2 (x = 1) de la figure 1 qui ont été obtenus, on peut citer les composés D, E, F et G correspondant respectivement aux formules :

- D : $NdMg(Ga_{0,85}Al_{0,15})_{11}O_{19}$

- E : $NdMg(Ga_{0,80}Al_{0,20})_{11}O_{19}$

- F : $NdMg(Ga_{0,60}Al_{0,40})_{11}O_{19}$

- G : $NdMg(Ga_{0,10}Al_{0,90})_{11}O_{19}$.

Pour x allant de 0,3 à 1 et v au plus égal à 0,1, il existe des composés monophasés de type magnétoplombite selon l'invention. Comme exemples, on peut citer les composés H et I répondant respectivement aux formules :

$La_{0,6}Nd_{0,4}Mg(Ga_{0,95}Al_{0,05})_{11}O_{19}$

$La_{0,4}Nd_{0,6}Mg(Ga_{0,9}Al_{0,1})_{11}O_{19}$.

De façon générale, les composés monophasés selon l'invention satisfaisant aux équations $0,3 \leq x \leq 1$ et $0 < v \leq 0,1$ sont ceux situés au-dessus de la droite 3 ayant pour point d'origine le point P(0,3-0), une pente d'environ 0,143 et pour point extrême le point Q(1-0,1). Autrement dit, lorsque $0,3 \leq x \leq 1$, v doit satisfaire à la relation v>0,143(x-0,3).

Pour v égale 1, on retrouve le LNA ne faisant pas partie de l'invention. Les composés de l'invention sont ceux situés en-dessous de la droite 4 (v=1) ayant pour origine le point S(0-1) et pour extrémité le point R(1-1).

Pour x égale 0, on obtient les composés solides de l'art antérieur de formule $LaMg(Ga_{1-v}Al_v)_{11}O_{19}$ ne présentant pas l'effet laser. La limite x=0 correspond à l'axe des ordonnées dont le point d'origine est 0(0-0) et le point d'extrémité S(0-1).

En conclusion les gallates de lanthane-néodyme-magnésium selon l'invention de formule $(La_{1-x}Nd_x)Mg(Ga_{1-v}Al_v)_{11}O_{19}$ sont ceux contenus dans le pentagone OPQRSO de la figure 1.

Comme composés particuliers appartenant à ce pentagone, on peut citer les composés J et K respectivement de formule :

$La_{0,9}Nd_{0,1}Mg(Ga_{0,1}Al_{0,9})_{11}O_{19}$

$La_{0,9}Nd_{0,1}Mg(Ga_{0,6}Al_{0,4})_{11}O_{19}$.

Ces gallates appartenant à la droite 5 (x=0,1) de la figure 1 correspondent au taux de néodyme choisi le plus couramment pour le LNA.

Les inventeurs ont trouvé que pour x=0,1 et v allant de 0 à 1, il existait une solution solide totale quelle que soit la valeur de v. Ces composés présentent une maille hexagonale et les paramètres cristallins de ces composés ont été mesurés.

La figure 2 illustre l'évolution continue de ces paramètres cristallins a et c de la maille hexagonale de ces composés en fonction de v, c'est-à-dire de la composition en aluminium ; la courbe $a_0$ représentant l'évolution du paramètre cristallin a et la courbe $c_0$ celle du paramètre cristallin c.

Les principales propriétés optiques ou effets laser des aluminogallates de lanthane-néodyme-magnésium selon l'invention (figure 1) sont liées à l'abaissement de la force du champ cristallin au site du néodyme lorsqu'on substitue l'aluminium par le gallium dans le LNA. Ceci ressort clairement de la figure 2.

De cette figure, il ressort que la distance néodyme-oxygène croît de l'aluminate pur au gallate pur. L'augmentation de cette distance permet de réduire le phénomène d'auto-extinction de la fluorescence du néodyme, permettant ainsi d'augmenter par rapport au LNA la quantité d'atomes actifs pour l'effet laser.

Les modifications du champ cristallin sont très favorables à la co-activation par les ions $Cr^{3+}$. En effet, l'abaissement du champ cristallin, par augmentation des distances néodyme-oxygène, par rapport au LNA, provoque un déplacement des bandes de fluorescence du chrome vers les grandes longueurs d'onde entre 700 et 800 nm, région où se trouvent justement les deux bandes intenses du spectre d'absorption du néodyme.

Par conséquent, les aluminogallates à base de néodyme sont beaucoup plus prometteurs que le LNA dans le cas d'une co-activation au chrome, cette co-activation améliorant sensiblement le rendement de l'émission laser. Ces aluminogallates présentent en particulier la formule :

$La_{1-x}Nd_xMg(Ga_{1-v-t}Al_vCr_t)_{11}O_{19}$

avec $0<x\leq 1$, $0\leq + t\ v<1$ et t0. Par exemple t vaut 0,005.

Comme autres exemples particuliers de gallates selon l'invention contenus dans le pentagone OPQRSO, on peut citer ceux pour lesquels v=0,4, c'est-à-dire correspondant à la formule :

$La_{1-x}Nd_xMg(Ga_{0,6}Al_{0,4})_{11}O_{19}$

schématisée par la droite 6 sur la figure 1. Plusieurs gallates répondant à cette formule, comme par exemple le composé L de formule $La_{0,5}Nd_{0,5}MgGa_{6,6}Al_{4,4}O_{19}$ ont été synthétisés et les inventeurs ont mesuré l'intensité de fluorescence $I_f$ de ces gallates.

Les variations de l'intensité de fluorescence $I_f$ avec la teneur en néodyme N de ces gallates sont représentées sur la figure 3 par la courbe 7. L'intensité de fluorescence présente un maximum pour x≈0,3.

Sur cette figure 3, on a aussi représenté les variations de l'intensité de fluorescence $I_f$ avec la teneur en néodyme du LNA de formule $La_{1-x}Nd_xMg(Al_{11}O_{19})$. Ces variations sont données par la courbe 8 et montrent un maximum pour x ≈0,1.

Ces courbes montrent qu'il est possible grâce à la substitution partielle de l'aluminium du LNA par du gallium d'accroître d'un facteur 3 dans le composé la quantité de néodyme correspondant au maximum d'intensité de fluorescence. Or, comme on l'a dit précédemment, l'intensité de fluorescence augmente avec la concentration en ions néodyme. Ceci ressort aussi des courbes 7 et 8 puisqu'il est possible d'obtenir une intensité de fluorescence double pour les gallates. Il est donc très intéressant de substituer une partie de l'aluminium par du gallium dans le LNA.

Inversement, du point de vue des gallates purs, la substitution partielle du gallium par l'aluminium autorise l'introduction du néodyme en toute proportion (x=1 et v=0 n'existant pas). En outre, cette substitution partielle du gallium par de l'aluminium permet l'élaboration de gros monocristaux de qualité convenable pour un grand nombre d'applications laser.

En effet, les gallates de lanthane-néodyme non substitués par de l'aluminium (courbe 1 de la figure 1) ne peuvent pas être obtenus sous forme de barreaux monocristallins de grande taille, la cristallogénèse de ces gallates purs s'avérant relativement difficile.

Toutefois, les monocristaux des gallates, non substitués par l'aluminium, de petites tailles, peuvent être intéressants pour la réalisation de microlasers. Les monocristaux sont obtenus par fusion de la poudre correspondante en creuset de platine, suivie d'un refroidissement lent.

Les aluminogallates de lanthane-néodyme-magnésium de composition $La_{1-x}Nd_xMg(Ga_{1-v}Al_v)_{11}O_{19}$ pour lesquels x va de 0,1 à 0,5 (bornes comprises) semblent un bon compromis en ce qui concerne la quantité

d'ions néodyme aussi bien en ce qui concerne la durée de vie de l'état excité $E_1$ qu'en ce qui concerne le rendement de fluorescence.

Sur la figure 3, x=0,1 correspond à une quantité de néodyme de l'ordre de $0{,}3.10^{21}$ ions $Nd^{3+}$ par $cm^3$ et x=0,5 correspond à environ $1{,}6.10^{21}$ ions $Nd^{3+}$ par $cm^3$.

Etant donné que la durée de vie de l'état excité $E_1$ décroît lorsque la quantité en néodyme croît et qu'inversement l'intensité de fluorescence augmente lorsque la quantité en néodyme croît, les monocristaux pour lesquels x=0,1 sont plus particulièrement adaptés à la réalisation de lasers de puissance fonctionnant en continu alors que les monocristaux pour x supérieur à 0,1 et en particulier égal à 0,2, 0,3 ou 0,4 sont mieux adaptés à la fabrication de lasers de puissance fonctionnant en impulsions.

En particulier, le spectre de fluorescence $J_f$, en unité arbitraire, donc d'émission laser du néodyme dans le domaine des transitions ${}^4F_{3/2}\rightarrow{}^4I_{11/2}$ responsable de cet effet laser est donné sur la figure 4. Ce spectre est celui du monocristal de formule :

$La_{0,95}Nd_{0,05}Mg(Ga_{0,45}Al_{0,55})_{11}O_{19}$

utilisable en particulier dans un laser de puissance moyenne, fonctionnant en continu. Ce spectre de fluorescence fait apparaître l'existence de deux longueurs d'onde principales d'émission à 1,057 et 1,083 micromètres.

Bien que cela n'apparaisse pas sur la courbe, ce composé présente aussi des longueurs d'onde d'émission au voisinage de 1,32 micromètres qui peuvent aussi donner l'effet laser.

Sur la figure 5, on a représenté schématiquement un laser de puissance pulsé utilisant un gallate mixte selon l'invention, émettant dans l'infrarouge. Ce laser comprend une cavité laser 10 contenant un barreau 12 de gallate selon l'invention disposé parallèlement à l'axe longitudinal 13 du laser. Ce gallate présente par exemple la formule :

$(La_{0,8}Nd_{0,2})_{0,87}Mg_{0,6}(Ga_{0,48}Al_{0,52})_{11,4}O_{19}$.

De part et d'autre de ce barreau 12 sont disposés des lampes flash au xénon de forte intensité 14 et 16, de forme allongée, orientées aussi selon l'axe longitudinal 13 du laser. Ces lampes 14 et 16 permettent d'assurer un pompage optique longitudinal du barreau de gallate 12 à base de néodyme.

La cavité laser 10 se compose aussi d'une lame quart d'onde 18 transformant la lumière incidente polarisée linéairement, issue du barreau 12, en lumière polarisée circulairement. Cette lame 18 est suivie d'un miroir plan 20 envoyant la lumière issue de la lame sur un miroir convexe divergent 22.

Après réflexion sur ce miroir 22, le faisceau lumineux élargi, adapté et polarisé circulairement, traverse à nouveau la lame quart d'onde 18 produisant ainsi un faisceau polarisé verticalement qui balaye complètement le milieu amplificateur ou barreau 12 en extrayant le maximum d'énergie lumineuse possible de ce barreau.

Le faisceau laser, amplifié dans la direction d'un autre miroir hautement réfléchissant concave 24 est interrompu par un prisme polariseur 26 éjectant le faisceau polarisé verticalement 28 hors du laser. Une lentille convergente 30 permet l'obtention d'un faisceau de lumière parallèle.

Ce laser fonctionnant en impulsions est équipé d'un interrupteur électro-optique 32, plus généralement désigné sous le vocable anglo-saxon de "$Q_1$ switch", disposé entre le miroir concave 24 et le polariseur de sortie 26. Lorsque cet interrupteur est fermé, c'est-à-dire qu'une tension lui est appliquée, le laser ne peut fonctionner. En effet, pendant que l'on "pompe" le milieu amplificateur avec les lampes au néon 14 et 16, le polariseur 26 est transparent aux photons polarisés horizontalement et laisse passer la lumière vers l'interrupteur 32. Celui-ci faisant tourner la direction de polarisation de 90° empêche le polariseur 26 de transmettre cette lumière.

Inversement, lorsqu'on ouvre l'interrupteur électro-optique 32, celui-ci n'altère plus la polarisation horizontale issue du polariseur permettant ainsi à la cavité laser 10 d'amplifier la lumière émise par le barreau 12.

Un diaphragme 33 peut être intercalé entre l'interrupteur et le polariseur pour canaliser la lumière laser.

Le remplacement du barreau 12 en gallate de néodyme-magnésium par un gallate selon l'invention de praséodyme-magnésium, par exemple de formule : $La_{1-x}Pr_xMgGa_{3,3}Al_{7,7}O_{19}$ ou $La_{1-x}Pr_xMgGa_{6,6}Al_{4,4}O_{19}$ avec $0<x<1$ conduit à un laser de puissance émettant dans le visible et en particulier dans le jaune et dans le rouge. Il convient simplement d'adapter le revêtement des miroirs 22 et 24 à la longueur d'onde d'émission laser recherchée.

De la même façon, on peut utiliser un barreau 12 contenant du cérium à la place du néodyme pour obtenir un laser de puissance accordable en longueur d'onde, émettant dans l'ultraviolet ou le visible et en particulier dans le bleu-violet. A cet effet, un composé de formule $La_{1-x}Ce_xMgGa_{5,5}Al_{5,5}O_{19}$ avec $0<x\leq1$ peut être utilisé.

Dans ce cas, afin d'accorder la longueur d'onde de ce laser, un dispositif de sélection en longueur d'onde 34, du type réseau ou prisme est intercalé entre la lame 18 et le miroir 20.

De même, on peut obtenir un laser de puissance accordable émettant dans le rouge et le proche infrarouge en utilisant un monocristal de gallate ou d'aluminogallate contenant comme activateur laser, du chrome, à la place du barreau 12 au néodyme.

Comme autres exemples d'aluminogallates de type magnétoplombite selon l'invention répondant à la formule (I) on peut citer les composés :

$La_{1-x}Nd_xMg(Ga_{0,3}Al_{0,6}Sc_{0,1})_{11}O_{19}$

$La_{1-x}Nd_xMg(Ga_{0,4}Al_{0,5}In_{0,1})_{11}O_{19}$

dans lesquels une partie de l'aluminium est substituée par du scandium ou de l'indium, z=t=0 et k=1.

Il est aussi possible de substituer totalement l'aluminium dans les gallates de l'invention par du scandium ou de l'indium comme le montrent les composés suivants :

$La_{0,9}Nd_{0,1}Mg(Ga_{0,9}Sc_{0,1})_{11}O_{19}$

$La_{0,9}Nd_{0,1}Mg(Ga_{0,9}In_{0,1})_{11}O_{19}$

Certains gallates selon l'invention de type magnétoplombite, présentant la formule (I), peuvent comporter des lacunes d'oxygène, ce qui correspond à k1. Comme exemple de gallate avec k1 on peut citer le composé :

$(La_{0,7}Nd_{0,3})_{0,98}Mg_{0,98}(Ga_{0,6}Al_{0,4})_{10,78}O_{18,62}$

dans lequel k=0,98, z=t=0.

D'autres types de laser que celui décrit ci-dessus peuvent bien entendu être équipés d'un monocristal de gallate selon l'invention, en particulier ceux dans lesquels le pompage optique s'effectue au moyen d'un laser et non de lampes.

A titre d'exemple, on décrit ci-après la fabrication de monocristaux d'aluminogallates selon l'invention, par tirage Czochralski, technique bien connue de l'homme de l'art.

La fusion des aluminogallates de type magnétoplombite selon l'invention n'étant en général pas congruante, le tirage de monocristaux n'est possible qu'à partir d'un bain fondu enrichi ou appauvri en l'un des constituants. Le matériau est fondu en creuset d'iridium sous une atmosphère neutre légèrement oxygénée. Un montage de matériau réfractaire (alumine + poudre de MgO) installée autour du creuset permet de limiter au maximum les gradients thermiques. Le chauffage du creuset est effectué par un four à induction. L'ensemble (creuset + four) est enfermé dans une enceinte hermétique, refroidie par de l'eau.

En l'absence de germes d'un nouveau composé selon l'invention, le tirage s'effectue à partir d'un porte-germe en iridium fendu. Celui-ci est animé d'un mouvement de rotation de 10 à 20 t/min. Il est nécessaire d'utiliser de très faibles vitesses de translation compte tenu de la différence de composition existant entre le bain et le cristal. Des vitesses de l'ordre de 0,5 à 1 mm par heure conduisent à de bons résultats.

A partir du cristal obtenu, on peut obtenir par clivage des lames monocristallines de bonne qualité permettant la caractérisation optique du composé ainsi que des barreaux de grande dimension utilisables comme source laser.

Le tableau ci-après donne des exemples de monocristaux d'aluminogallates de lanthane-néodyme-magnésium obtenus par tirage Czochralski : la partie gauche du tableau donne la composition en mole % du bain fondu à partir duquel est obtenu le monocristal, et la partie droite du tableau donne la formule du monocristal obtenu à partir du bain fondu correspondant.

**EXEMPLES DE MONOCRISTAUX OBTENUS PAR TIRAGE CZOCHRALSKI**

| Composition du bain fondu en mole % | | | | | Cristal obtenu à partir du bain fondu |
|---|---|---|---|---|---|
| $La_2O_3$ | $Nd_2O_3$ | MgO | $Ga_2O_3$ | $Al_2O_3$ | Composition |
| 14,84 | 1,76 | 10,86 | 47,60 | 24,94 | $(La_{0,95}Nd_{0,05})Mg_1(Ga_{0,45}Al_{0,55})_{11}O_{19}$ |
| 16,71 | 2,55 | 10,37 | 47,96 | 22,41 | $(La_{0,90}Nd_{0,10})Mg_1(Ga_{0,45}Al_{0,55})_{11}O_{19}$ |
| 6,92 | 0,77 | 7,69 | 50,79 | 33,83 | $(La_{0,95}Nd_{0,05})_{0,87}Mg_{0,6}(Ga_{0,37}Al_{0,63})_{11,4}O_{19}$ |
| 6,97 | 0,79 | 7,70 | 51,40 | 33,14 | $(La_{0,95}Nd_{0,05})_{0,87}Mg_{0,6}(Ga_{0,44}Al_{0,56})_{11,4}O_{19}$ |
| 7,10 | 1,11 | 7,49 | 53,31 | 30,99 | $(La_{0,90}Nd_{0,10})_{0,87}Mg_{0,6}(Ga_{0,46}Al_{0,54})_{11,4}O_{19}$ |
| 7,24 | 1,29 | 7,67 | 55,84 | 27,96 | $(La_{0,88}Nd_{0,12})_{0,87}Mg_{0,6}(Ga_{0,48}Al_{0,52})_{11,4}O_{19}$ |
| 7,16 | 2,39 | 7,59 | 55,21 | 27,65 | $(La_{0,80}Nd_{0,20})_{0,87}Mg_{0,6}(Ga_{0,48}Al_{0,52})_{11,4}O_{19}$ |

## Revendications

1. Gallate mixte de lanthanide-magnésium, caractérisé en ce qu'il présente la formule suivante :

$$\left[La_{1-x}M^1_x\right]_{(1-z/3)k}Mg_{(1-z)k}\left[Ga_{1-v-t}M^2_vCr_t\right]_{(11+z)k}O_{19k}$$

dans laquelle $M^1$ est choisi parmi le néodyme, le praséodyme, le cérium, les couples néodyme-cérium et praséodyme-cérium, ces éléments étant trivalents ; $M^2$ représente au moins un élément trivalent choisi parmi l'aluminium, le scandium et/ou l'indium à condition que le nombre d'atomes totaux de scandium et d'indium par unité formulaire soit inférieur à 0,15(11+z)k ; k représente un nombre allant de 0,94 à 1 ; x représente un nombre allant de 0 à 1 ; t représente un nombre tel que $0 \leq t \leq 0,05$ à condition que t soit 0, lorsque x=0 et que x soit 0 lorsque t=0 ; v représente un nombre tel que $0 \leq v+t < 1$ ; z représente un nombre allant

de 0 à 0,5 ; et en ce que le gallate est monophasé et présente une structure cristalline du type magnétoplombite.

2. Gallate mixte selon la revendication 1, caractérisé en ce que $M^2$ représente l'aluminium.

3. Gallate mixte selon la revendication 1 ou 2, caractérisé en ce que $M^1$ représente le néodyme.

4. Gallate mixte selon la revendication 3, caractérisé en ce qu'il présente la formule suivante :

$La_{1-x}Nd_xMg(Ga_{1-v}Al_v)_{11}O_{19}$

à condition que $v>0,143(x-0,3)$ pour $0,3\leq x\leq 1$.

5. Gallate mixte selon l'une quelconque des revendications 1 à 4, caractérisé en ce qu'il présente la formule suivante :

$La_{1-x}Nd_xMgGa_{6,6}Al_{4,4}O_{19}$, avec $0<x\leq 1$.

6. Gallate mixte selon l'une quelconque des revendications 3 à 5, caractérisé en ce que x varie de 0,1 à 0,5.

7. Gallate mixte selon la revendication 3 ou 4, caractérisé en ce qu'il présente la formule suivante :

$La_{1-x}Nd_xMgGa_{11}O_{19}$

dans laquelle x est tel que $0<x<0,3$.

8. Gallate mixte selon l'une quelconque des revendications 3 à 5, caractérisé en ce que x=1 et v est supérieur à 0,1.

9. Gallate mixte selon la revendication 1 ou 2, caractérisé en ce qu'il présente la formule suivante :

$La_{1-x}Nd_{1-p}Ce_p)_xMg(Ga_{1-v}Al_{v11}O_{19}$
p étant un nombre tel que $0\leq p\leq 1$.

10. Gallate mixte selon la revendication 9, caractérisé en ce que v vaut 0,5 et x vaut 0,2 ou 0,5.

11. Gallate mixte selon l'une quelconque des revendications 1 à 3, caractérisé en ce qu'il présente la formule suivante :

$La_{1-x}Nd_xMg(Ga_{1-v-t}Al_vCr_t)_{11}O_{19}$

avec $0<x\leq 1$, $0\leq v+t<1$ et t0.

12. Gallate mixte selon la revendication 1 ou 2, caractérisé en ce qu'il présente la formule suivante :

$La_{1-x}Pr_xMg(Ga_{1-v}Al_v)_{11}O_{19}$ avec $0<x\leq 1$.

13. Gallate mixte selon la revendication 11, caractérisé en ce que v vaut 0,7 ou 0,4.

14. Gallate mixte selon la revendication 1 ou 2, caractérisé en ce qu'il présente la formule suivante :

$LaMg(Ga_{1-v-t}Al_vCr_t)_{11}O_{19}$

avec $0\leq v+t<1$ et t0.

15. Laser de puissance émettant dans l'infrarouge, caractérisé en ce qu'il comprend un monocristal d'un gallate mixte selon l'une quelconque des revendications 3 à 11.

16. Laser de puissance émettant dans le visible, caractérisé en ce qu'il comprend un monocristal d'un gallate mixte selon l'une quelconque des revendications 1, 2, 12 et 13, dans lequel $M^1$ est le praséodyme ou le couple praséodyme-cérium.

17. Laser de puissance émettant dans l'ultraviolet ou le visible, caractérisé en ce qu'il comprend un monocristal d'un gallate mixte selon la revendication 1 ou 2, dans lequel $M^1$ est le cérium.

18. Laser de puissance accordable dans le rouge et le proche infrarouge, caractérisé en ce qu'il comprend un monocristal d'un gallate mixte selon la revendication 14.

**Patentansprüche**

1. Lanthaniden-Magnesium-Mischgallat, dadurch gekennzeichnet, daß es die folgende Formel hat:

$$\left[La_{1-x}M^1_x\right]_{(1-z/3)k}Mg_{(1-z)k}\left[Ga_{1-v-t}M^2_vCr_t\right]_{(11+z)k}O_{19k}$$

worin bedeuten:
$M^1$ ein trivalentes Element, ausgewählt aus der Gruppe Neodym, Praseodym, Cer, der Paare Neodym-Cer und Praseodym-Cer;

$M^2$ mindestens ein trivalentes Element, ausgewählt aus der Gruppe Aluminium, Scandium und/oder Indium mit der Maßgabe, daß die Gesamtanzahl der Atome von Scandium und Indium pro Formeleinhiet unter 0,15 (11+z)k liegt;
k eine Zahl, die von 0,94 bis 1 geht;
x eine Zahl, die von 0 bis 1 geht;
t eine solche Zahl, daß $0 \leq t \leq 0{,}05$ mit der Maßgabe, daß $t \neq 0$, wenn $x = 0$, und daß $x \neq 0$, wenn $t = 0$;
v eine solche Zahl, daß $0 \leq v + t < 1$; und
daß das Gallat monophasisch ist und eine Kristallstruktur vom Magnetoplombit-Typ hat.

2. Mischgallat nach Anspruch 1, dadurch gekennzeichnet, daß $M^2$ Aluminium bedeutet.

3. Mischgallat nach Anspruch 1 oder 2, dadurch gekennzeichnet, daß $M^1$ Neodym bedeutet.

4. Mischgallat nach Anspruch 3, dadurch gekennzeichnet, daß es die folgende Formel hat:
$La_{1-x}Nd_xMg(Ga_{1-v}Al_v)_{11}O_{19}$
mit der Maßgabe, daß $v > 0{,}143\ (x-0{,}3)$ für $0{,}3 \leq x \leq 1$.

5. Mischgallat nach einem der Ansprüche 1 bis 4, dadurch gekennzeichnet, daß es die folgende Formel hat:
$La_{1-x}Nd_xMgGa_{6,6}Al_{4,4}O_{19}$, mit $0 < x \leq 1$

6. Mischgallat nach einem der Ansprüche 3 bis 5, dadurch gekennzeichnet, daß x von 0,1 bis 0,5 variiert.

7. Mischgallat nach Anspruch 3 oder 4, dadurch gekennzeichnet, daß es die folgende Formel hat:
$La_{1-x}Nd_xMgGa_{11}O_{19}$
worin x eine solche Zahl ist, daß $0 < x < 0{,}3$.

8. Mischgallat nach einem der Ansprüche 3 bis 5, dadurch gekennzeichnet, daß $x = 1$ und v eine Zahl über 0,1 bedeutet.

9. Mischgallat nach Anspruch 1 oder 2, dadurch gekennzeichnet, daß es die folgende Formel hat:
$La_{1-x}(Nd_{1-p}Ce_p)_xMg(Ga_{1-v}Al_v)_{11}O_{19}$
worin p eine solche Zahl bedeutet, daß $0 \leq p \leq 1$.

10. Mischgallat nach Anspruch 9, dadurch gekennzeichnet, daß v für die Zahl 0,5 und x für die Zahl 0,2 oder 0,5 stehen.

11. Mischgallat nach einem der Ansprüche 1 bis 3, dadurch gekennzeichnet, daß es die folgende Formel hat:
$La_{1-x}Nd_xMg(Ga_{1-v-t}Al_vCr_t)_{11}O_{19}$
mit $0 < x \leq 1$, $0 \leq v + t < 1$ und $t \neq 0$.

12. Mischgallat nach Anspruch 1 oder 2, dadurch gekennzeichnet, daß es die folgende Formel hat:
$La_{1-x}Pr_xMg(Ga_{1-v}Al_v)_{11}O_{19}$ mit $0 < x \leq 1$

13. Mischgallat nach Anspruch 11, dadurch gekennzeichnet, daß v die Zahl 0,7 oder 0,4 bedeutet.

14. Mischgallat nach Anspruch 1 oder 2, dadurch gekennzeichnet, daß es die folgende Formel hat
$LaMg(Ga_{1-v-t}Al_vCr_t)_{11}O_{19}$
mit $0 \leq v + t < 1$ und $t \neq 0$.

15. Energie-Laser, der IR-Strahlung emittiert, dadurch gekennzeichnet, daß er einen Einkristall eines Mischgallats nach einem der Anprüche 3 bis 11 umfaßt.

16. Energie-Laser, der Strahlung im sichtbaren Bereich emittiert, dadurch gekennzeichnet, daß er einen Einkristall eines Mischgallats nach einem der Ansprüche 1, 2, 12 und 13 umfaßt, in dem $M^1$ für Praseodym oder das Paar Praseodym-Cer steht.

17. Energielaser, der UV-Strahlung oder Strahlung im sichtbaren Bereich emittiert, dadurch gekennzeichnet, daß er einen Einkristall eines Mischgallats nach Anspruch 1 oder 2 umfaßt, worin $M^1$ für Cer steht.

18. Energielaser, der auf den roten und nahen infraroten Bereich abstimmbar ist, dadurch gekennzeichnet, daß er einen Einkristall eines Mischgallats nach Anspruch 14 umfaßt.

## Claims

1. Mixed lanthanide-magnesium gallate, characterized in that it is of formula:

$$\left[La_{1-x}M^1_x\right]_{(1-z/3)k}Mg_{(1-z)k}\left[Ga_{1-v-t}M^2_vCr_t\right]_{(11+z)k}O_{19k}$$

in which $M^1$ is chosen from among neodymium, praseodymium, cerium, neodymium-cerium and praseodymium-cerium pairs, said elements being trivalent; $M^2$ represents at least one trivalent element chosen from among aluminium, scandium and/or indium, provided that the total number of scandium and indium atoms per formula unit is below 0.15(11+z)k; k represents a number between 0.94 and 1; x represents a number between 0 and 1; t represents a number such that $0 \leq t \leq 0.05$, provided that t is $\neq 0$, when $x = 0$ and x is $\neq 0$ when $t = 0$; v represents a number such that $0 \leq v+t < 1$; z represents a number between 0

and 0.5 and wherein the gallate is monophase and has a magnetoplumbite-type crystalline structure.

2. Mixed gallate according to claim 1, characterized in that $M^2$ represents aluminium.

3. Mixed gallate according to claims 1 or 2, characterized in that $M^1$ represents neodymium.

4. Mixed gallate according to claim 3, characterized in that it is of formula:

$La_{1-x}Nd_xMg(Ga_{1-v}Al_v)_{11}O_{19}$

provided that $v > 0.143(x-0.3)$ for $0.3 \leq x \leq 1$.

5. Mixed gallate according to any one of the claims 1 to 4, characterized in that it is of formula:

$La_{1-x}Nd_xMgGa_{6.6}Al_{4.4}O_{19}$, with $0 < x \leq 1$.

6. Mixed gallate according to any one of the claims 3 to 5, characterized in that x varies from 0.1 to 0.5.

7. mixed gallate according to claims 3 or 4, characterized in that it is of formula:

$La_{1-x}Nd_xMgGa_{11}O_{19}$

in which x is such that $0 < x < 0.3$.

8. Mixed gallate according to any one of the claims 3 to 5, characterized in that $x = 1$ and v exceeds 0.1.

9. Mixed gallate according to claims 1 or 2, characterized in that it is of the following formula:

$La_{1-x}(Nd_{1-p}Ce_p)_xMg(Ga_{1-v}Al_v)_{11}O_{19}$

p being a number such that $0 \leq p \leq 1$.

10. Mixed gallate according to claim 9, characterized in that v equals 0.5 and x equals 0.2 or 0.5.

11. Mixed gallate according to any one of the claims 1 to 3, characterized in that it is of the following formula:

$La_{1-x}Nd_xMg(Ga_{1-v-t}Al_vCr_t)_{11}O_{19}$

with $0 < x \leq 1, 0 \leq v + t < 1$ and $t \neq 0$.

12. Mixed gallate accoding to claims 1 or 2, characterized in that it is of formula:

$La_{1-x}Pr_xMg(Ga_{1-v}Al_v)_{11}O_{19}$ with $0 < x \leq 1$.

13. Mixed gallate according to claim 11, characterized in that v equals 0.7 or 0.4.

14. Mixed gallate according to claims 1 or 2, characterized in that it is of the folloiwng formula:

$LaMg(Ga_{1-v-t}Al_vCr_t)_{11}O_{19}$

with $0 \leq v + t < 1$ and $t \neq 0$.

15. Power laser emitting in the infrared, characterizd in that it comprises a monocrystal of a mixed gallate according to any one of the claims 3 to 11.

16. Power laser emitting in the visible range, characterized in that it comprises a monocrystal of a mixed gallate according to any one of the claims 1, 2, 12 and 13, in which $M^1$ is praseodymium or the praseodymium-cerium pair.

17. Power laser emitting in the ultraviolet or visible, characterized in that it comprises a monocrystal of a mixed gallate according to claims 1 or 2, in which $M^1$ is cerium.

18. Power laser tunable in the red and near infrared, characterized in that it comprises a monocrystal of a mixed gallate according to claim 14.

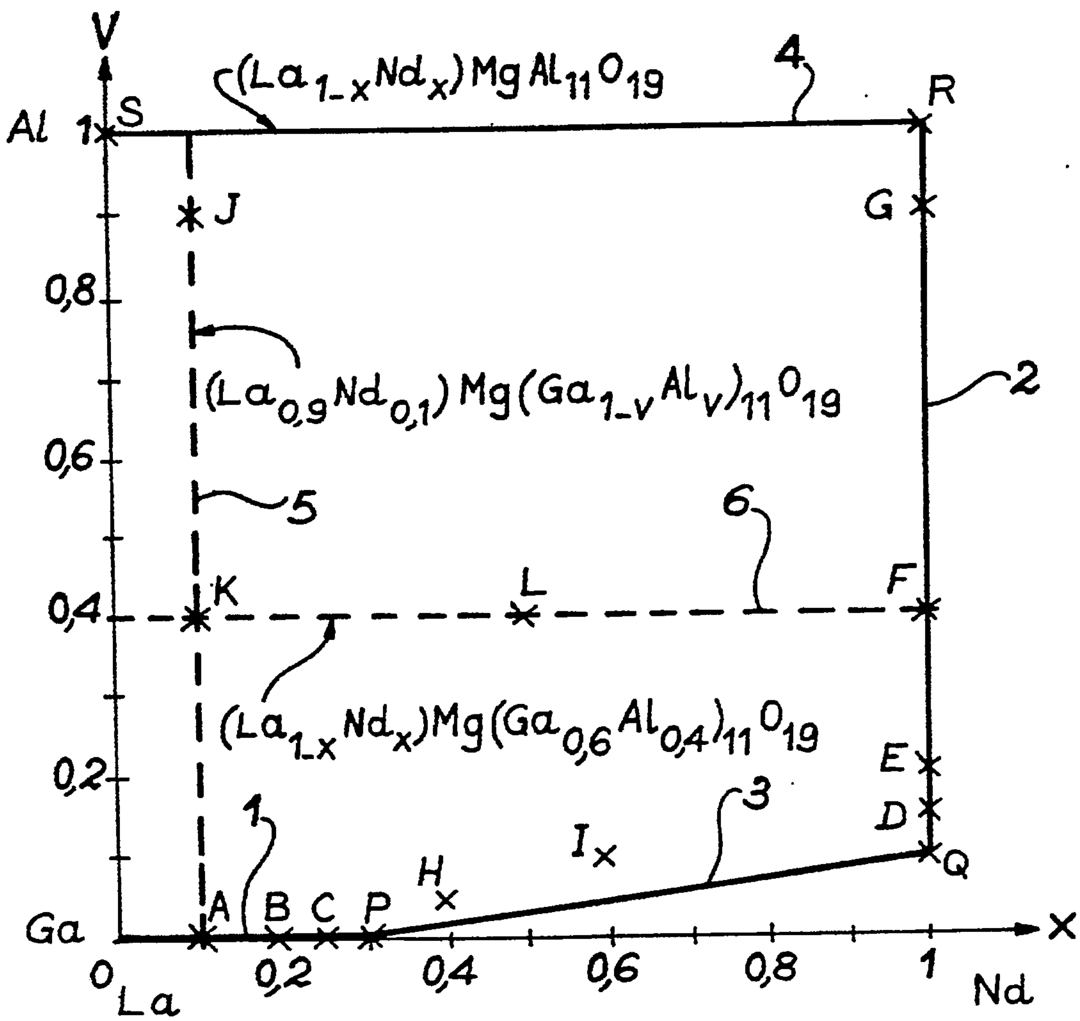
V
Al
1
S
R
4
$(La_{1-x}Nd_x)MgAl_{11}O_{19}$
J
G
0,8
$(La_{0,9}Nd_{0,1})Mg(Ga_{1-v}Al_v)_{11}O_{19}$
2
0,6
5
6
K
L
F
0,4
$(La_{1-x}Nd_x)Mg(Ga_{0,6}Al_{0,4})_{11}O_{19}$
E
0,2
3
D
1
I
Q
H
Ga
A
B
C
P
X
0
La
0,2
0,4
0,6
0,8
1
Nd

FIG. 1

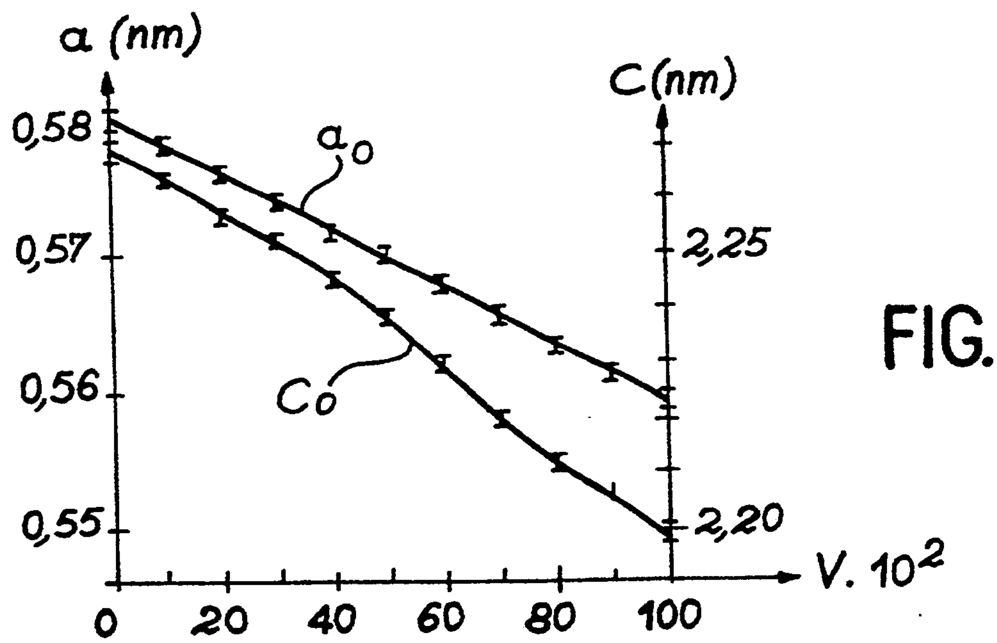
a (nm)
C(nm)
0,58
$a_0$
0,57
2,25
0,56
Co
0,55
2,20
$V.10^2$
0
20
40
60
80
100

FIG. 2

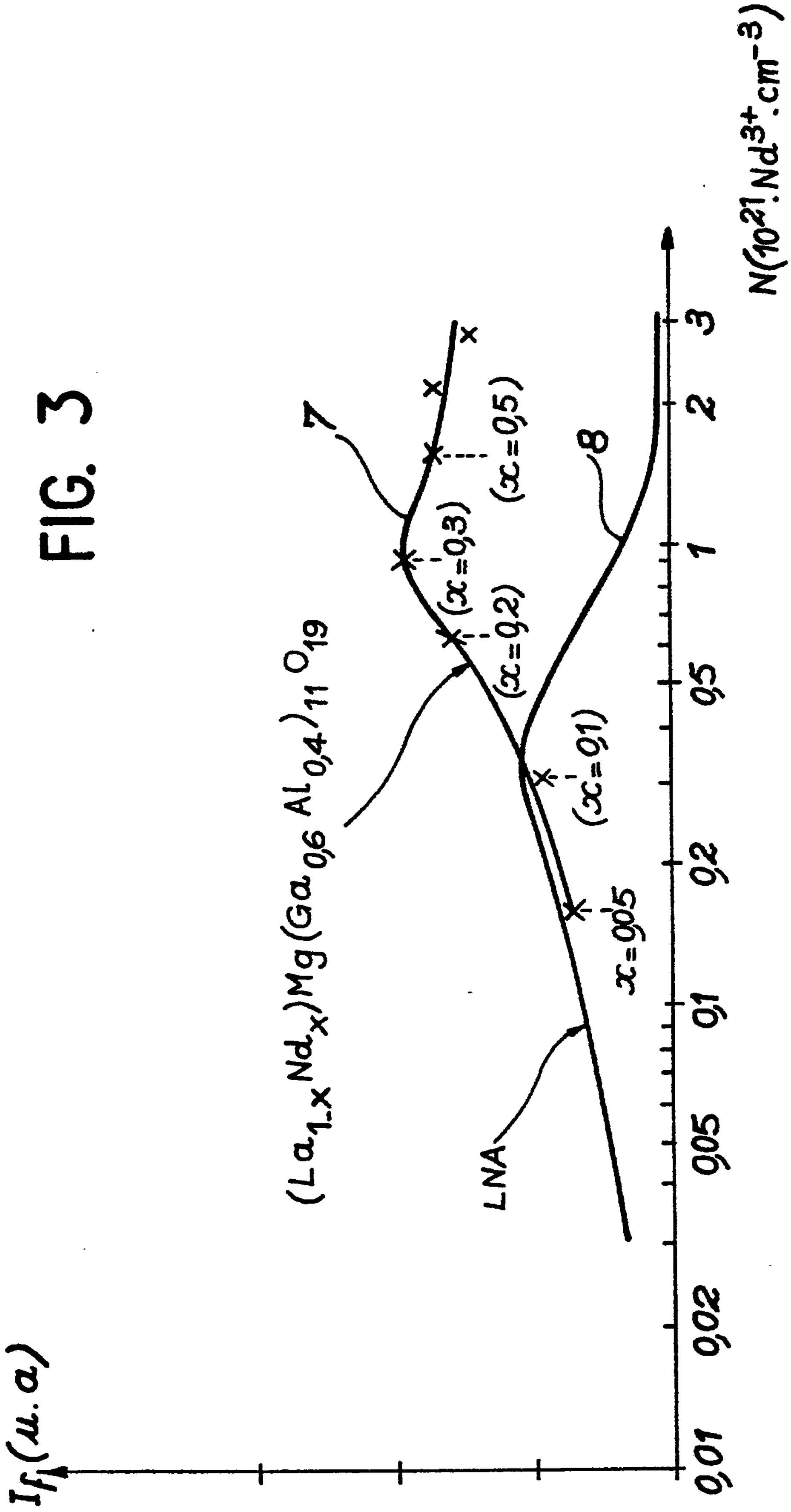
N(10^21.Nd^3+.cm^-3)
I_f(u.a)
(La_1-x Nd_x)Mg(Ga_0,6 Al_0,4)_11 O_19
LNA
7
8
x=0,05
(x=0,1)
(x=0,2)
(x=0,3)
(x=0,5)
0,01
0,02
0,05
0,1
0,2
0,5
1
2
3

FIG. 3

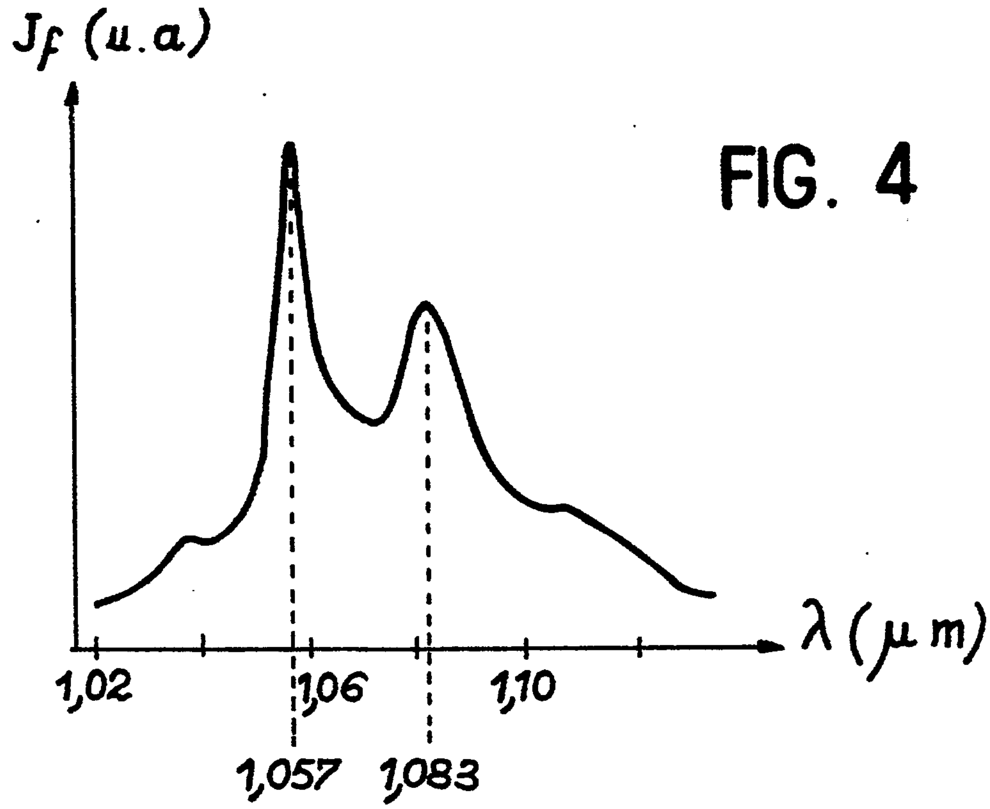
Jf (u.a)
λ (μm)
1,02
1,06
1,10
1,057
1,083

FIG. 4

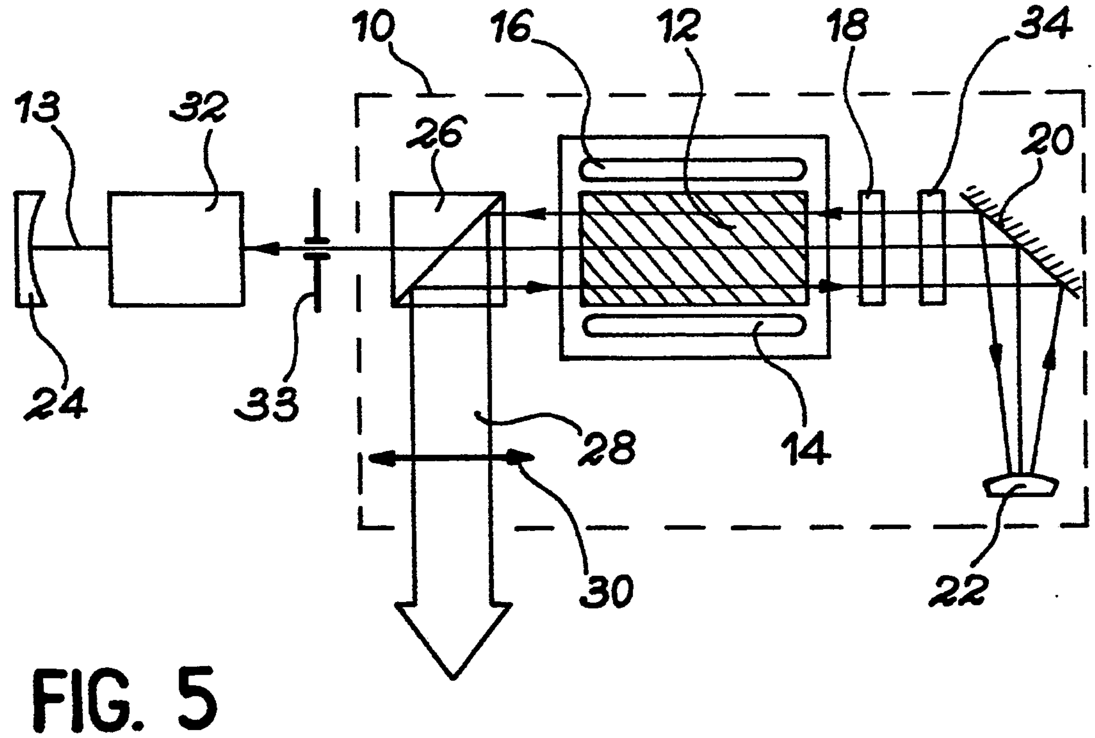
10
16
12
18
34
13
32
26
20
24
33
28
14
30
22

FIG. 5